# EUROPEAN PATENT APPLICATION

(11) **EP 4 765 647 A1**
(43) Date of publication of application: **24.06.2026**
(21) Application number: 25211977.1
(22) Date of filing: 29.10.2025
(51) Int. Cl.: H03M 1/66, H03H 17/02

(54) **CIRCUITS AND METHODS FOR CONVERTING A WIDEBAND DIGITAL SIGNAL INTO A WIDEBAND ANALOG SIGNAL**

(30) Priority: 19.12.2024 US 202418987557
(71) Applicant: Altera Corporation, San Jose, CA 95134 (US)
(72) Inventor: PRITSKER, Dan, San Diego (US)
(74) Representative: Viering, Jentschura & Partner mbB Patent- und Rechtsanwälte

(57) **Abstract**

An integrated circuit includes filter circuits that partition a wideband digital signal in a frequency domain to generate narrowband digital signals each having a different frequency band, digital-to-analog converter circuits that convert the narrowband digital signals to generate analog signals, and an analog combiner circuit that combines the analog signals into a single wideband analog signal.

## Description

### BACKGROUND

Configurable integrated circuits (ICs) can be configured by users to implement desired custom logic functions. In a typical scenario, a logic designer uses computer-aided design (CAD) tools to design a custom circuit design. When the design process is complete, the computer-aided design tools generate an image containing configuration data bits. The configuration data bits are then loaded into configuration memory elements that configure configurable logic circuits in the configurable integrated circuit to perform the functions of the custom circuit design.

### BRIEF DESCRIPTION OF DRAWINGS

Figure 1 is a diagram that illustrates an example of conversion circuitry that can convert a wideband digital signal into a wideband analog signal.
Figure 2 is a diagram that illustrates an example of conversion circuitry that can convert a wideband digital signal into a wideband analog signal by under sampling digital-to-analog converter circuits.
Figure 3 is a diagram that illustrates an example of a configurable logic integrated circuit that can implement techniques disclosed herein.
Figure 4A is a block diagram of a system that can be used to implement a circuit design to be programmed into a programmable logic device using design software.
Figure 4B is a diagram that depicts an example of a programmable logic device that includes fabric dies and base dies that are connected to one another via microbumps.
Figure 5 is a block diagram illustrating a computing system configured to implement one or more aspects of the techniques disclosed herein.

### DETAILED DESCRIPTION

Wideband digital-to-analog converters (DACs) have become more accessible commercially as a result of technology availability and applications, such as communication, test, and measurement applications. Wideband DACs allows agile response to wideband electronic threats to protect assets and evade detection and interception.

The sample rate of a DAC defines the instantaneous bandwidth (IBW) of the DAC through a Nyquist theorem. To expand the sample rate beyond the technological limitations of individual digital-to-analog converter (DAC) channels, a previously known method combines multiple DACs into one higher sample rate DAC channel. This previously known method is based on time interleaving, in which each DAC generates a different sample, while a delay block staggers the samples produced by each of the DACs. This method usually causes inaccuracies and errors in positioning the staggered samples or unbalanced gain in different paths. As a result, the combined interleaved DACs generate a variety of interfering signals (e.g., spurs). These spurs require very sophisticated methods to measure, calibrate, and compensate to reduce the effects of the spurs on the output.

According to some examples disclosed herein, conversion circuitry is provided that converts a wideband digital signal into a wideband analog signal. The conversion circuitry includes filter circuits (e.g., in a channelizer or an analysis filter bank) that separate the wideband digital signal into narrowband digital signals in multiple frequency bands that are each shifted to a baseband. The conversion circuitry also includes two or more digital-to-analog converter (DAC) circuits. Each of the DAC circuits converts one of the narrowband digital signals into a corresponding analog signal. The conversion circuitry also includes an analog combiner circuit that combines the analog signals generated by the DAC circuits in the frequency domain to generate a wideband analog signal. Additional processing circuitry performs additional preprocessing of the wideband analog signal, such as radio frequency summation and/or potential filtering of the analog signals generated by the DACs.

The conversion circuitry disclosed herein provides a breakthrough ability to expand applicational capability of new or existing hardware implementations of DAC circuits in integrated circuits (ICs) to support new classes of applications and systems. Because the wideband digital signal is separated in the frequency domain using digital filter circuits and provided to separate DACs, the conversion circuitry disclosed herein does not generate the analog errors that are typically generated by previously known DAC time-interleave switching. As a result, the conversion circuitry disclosed herein generates a signal that is more controlled and does not generate additional spurs related to analog imbalances.

One or more specific examples are described below. In an effort to provide a concise description of these examples, not all features of an actual implementation are described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

Throughout the specification, and in the claims, the terms "connected" and "connection" mean a direct electrical connection between the circuits that are connected, without any intermediary devices. The terms "coupled" and "coupling" mean either a direct electrical connection between circuits or an indirect electrical connection through one or more passive or active intermediary devices that allows the transfer of information between circuits. The term "circuit" may mean one or more passive and/or active electrical components that are arranged to cooperate with one another to provide a desired function.

This disclosure discusses integrated circuit devices, including configurable (programmable) logic integrated circuits, such as field programmable gate arrays (FPGAs) and programmable logic devices. As discussed herein, an integrated circuit (IC) can include hard logic and/or soft logic. The circuits in an integrated circuit device (e.g., in a configurable logic IC) that are configurable by an end user are referred to as "soft logic." "Hard logic" generally refers to circuits in an integrated circuit device that have substantially fewer configurable features than soft logic or no configurable features.

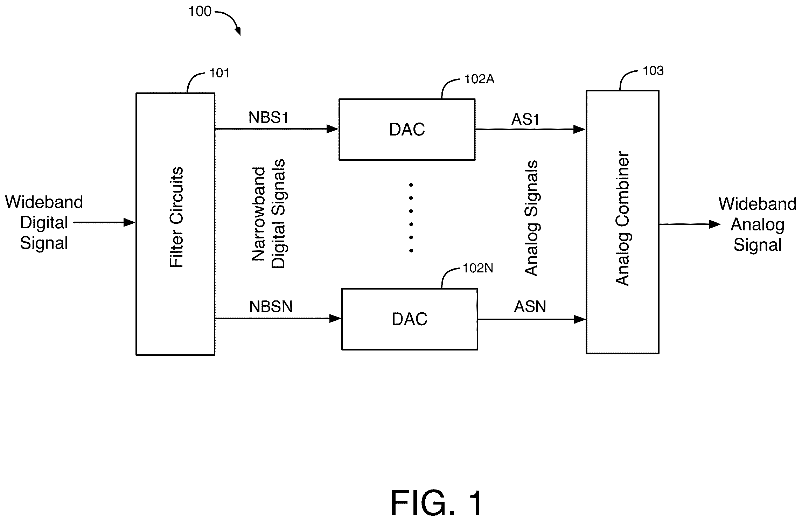

Figure 1 is a diagram that illustrates an example of conversion circuitry 100 that can convert a wideband digital signal into a wideband analog signal. Conversion circuitry 100 can be fabricated in any type of integrated circuit (IC), such as a configurable IC (e.g., a field programmable gate array (FPGA) or programmable logic device), a microprocessor IC, a graphics processing unit IC, a memory IC, an application specific IC, a transceiver IC, etc. Conversion circuitry 100 can also be fabricated in multiple integrated circuits.

Conversion circuitry 100 includes filter circuits 101, two or more digital-to-analog converter (DAC) circuits 102 (including DAC circuits 102A and 102N), and analog combiner circuit 103. The filter circuits 101 receive a wideband digital signal as an input. The filter circuits 101 filter and separate the wideband digital signal into multiple narrowband digital signals (e.g., signals NBS1 ... NBSN) having filtered and separated frequency bands. The filter circuits 101 partition the wideband digital signal in the frequency domain to generate narrowband digital signals that each has a different frequency band. The filter circuits 101 generate each of the narrowband digital signals at a baseband. Each of the narrowband digital signals is converted to baseband to match to a typical DAC circuit that expects the data to be at baseband. The conversion to baseband can be performed using multiple different techniques. As an example, the narrowband digital signals can be explicitly filtered and frequency translated to baseband. As another example, digital decimation can be performed to create an aliased copy of each narrowband digital signal at baseband, and then all of the other copies can be filtered except the one copy at baseband.

The filter circuits 101 cause each of the narrowband digital signals to have signals within a different frequency band of the wideband digital signal. The narrowband digital signals together include the frequency bands of the wideband digital signal. The frequency band of each of the narrowband digital signals fits a channel that includes one of the DAC circuits 102. The filter circuits 101 can be, for example, digital filter circuits if the number of narrowband signals generated is small.

The conversion circuitry 100 includes conductors that transmit each of the narrowband digital signals to one or more inputs of one of the DAC circuits 102. Thus, each of the separated and filtered frequency bands generated by the filter circuits 101 is provided to one of the DAC circuits 102. As examples, filter circuits 101 generate a first narrowband digital signal NBS1 that is transmitted to an input of DAC circuit 102A, and filter circuits 101 generate an Nth narrowband digital signal NBSN that is transmitted to an input of DAC circuit 102N. Each of the DAC circuits 102 converts one of the narrowband digital signals into an analog narrowband signal. As examples, DAC circuit 102A converts the first narrowband digital signal NBS1 into a first analog signal AS1, and DAC circuit 102N converts the Nth narrowband digital signal NBSN into an Nth analog signal ASN. The conversion circuitry 100 can include additional DAC circuits 102 that convert additional narrowband digital signals generated by the filter circuits 101 into additional analog signals.

DAC circuits 102 relocate each of the individual bands of the narrowband digital signals so that the frequency bands of the analog signals are interleaved in frequency, while providing sufficient overlap for an undistorted wideband spectrum. According to a first example, each of the DAC circuits 102 has a direct-RF (radio frequency) DAC architecture that has high output sample rates and can generate a narrowband analog signal anywhere within its RF band to create the frequency interleave between the multiple analog signals generated by the DAC circuits 102. According to a second example, the DAC circuits 102 are under sampling DAC circuits that create multiple copies of narrowband analog signals at different Nyquist zones of their output sample rates. In this second example, an analog filter is used to select different Nyquist zones for each one of the DACs 102A-N.

The DAC circuits 102 are frequency interleaved so that the desired wideband analog signal does not have any spectrum "holes" or distortions. In order to prevent any spectrum "holes" or distortions, the filter circuits 101 can cause each of the narrowband digital signals to have a frequency band transition shaped in a way that adjacent stacked bands fill-in and complement the transition band to obtain a flat seam.

Each of the analog signals generated by the DAC circuits 102 is provided to one of the inputs of the analog combiner circuit 103. The analog combiner circuit 103 receives each of the analog signals that are generated by the DAC circuits 102. The analog combiner circuit 103 combines all of the analog signals generated by the DAC circuits 102 into a single wideband analog signal. Thus, the analog combiner circuit 103 combines the frequency bands of the analog signals AS1, ASN, and possibly other analog signals generated by other DAC circuits 102 to generate the frequency band of the wideband analog signal. The analog combiner circuit 103 generates a contiguous and non-distorted frequency spectrum in the wideband analog signal. The analog combiner circuit 103 can, for example, include multiple radio-frequency (RF) analog signal combiner circuits that combine the analog signals to generate the wideband analog signal. As a result, the conversion circuitry 100 implements a DAC function having a wider instantaneous bandwidth (IBW) than the individual DAC circuits 102.

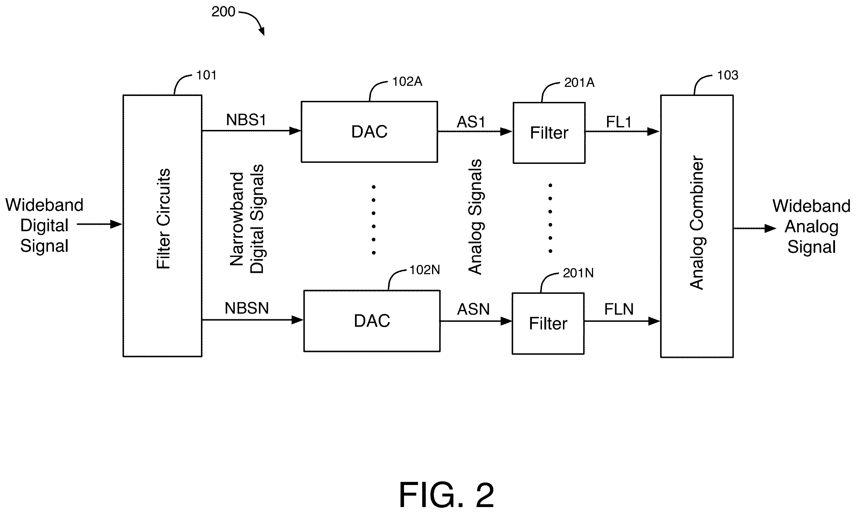

In an implementation where the DAC circuits 102 are not direct radio frequency (RF), the DAC circuits 102 can generate analog signals in 2 or 3 Nyquist zones. In this implementation, each one of the DAC circuits 102 operating in different Nyquist zones is filtered using analog filters to avoid undesired Nyquist zones from existing on each channel. In addition, a signal spectrum on even Nyquist zones can be digitally inverted to create an analog output spectrum that is aligned with the desired input signal. Figure 2 illustrates an example of this implementation.

Figure 2 is a diagram that illustrates an example of conversion circuitry 200 that can convert a wideband digital signal into a wideband analog signal using under sampling digital-to-analog converters. Conversion circuitry 200 can be fabricated in any type of integrated circuit (IC), such as a configurable IC (e.g., a field programmable gate array (FPGA) or programmable logic device), a microprocessor IC, a graphics processing unit IC, a memory IC, an application specific IC, a transceiver IC, etc. or in multiple ICs.

Conversion circuitry 200 includes filter circuits 101, two or more digital-to-analog converter (DAC) circuits 102 (including DAC circuits 102A and 102N), two or more analog filter circuits 201 (including analog filter circuits 201A and 201N), and analog combiner circuit 103. Filter circuits 101, DAC circuits 102, and analog combiner circuit 103 in conversion circuitry 200 operate as described above with respect to FIG. 1.

In the example of FIG. 2, analog filter circuits 201 filter the analog signals generated by DAC circuits 102 to generate filtered signals. As examples, analog filter circuit 201A filters analog signal AS1 generated by DAC circuit 102A to generate a first filtered signal FL1, and analog filter circuit 201N filters analog signal ASN generated by DAC circuit 102N to generate an Nth filtered signal FLN. Conversion circuitry 200 can include additional analog filter circuits 201 that filter additional analog signals generated by DAC circuits 102 to generate additional filtered signals. The analog filter circuits 201 can digitally invert the signal spectrum on even Nyquist zones to create an analog output spectrum in the filtered signals that is aligned with the desired input signal. In the example of FIG. 2, the DAC circuits 102 are under sampling DAC circuits that create multiple copies of narrowband analog signals at different Nyquist zones of their output sample rates, and the analog filter circuits 201 are used to select different Nyquist zones for each one of the DAC circuits 102.

In the example of FIG. 2, the analog combiner circuit 103 receives each of the filtered signals FL1 ... FLN that are generated by the analog filter circuits 201. The analog combiner circuit 103 combines all of the filtered signals FL1 ... FLN generated by the analog filter circuits 201A ... 201N into a single wideband analog signal. The analog combiner circuit 103 combines the frequency bands of the filtered signals FL1, FLN, and possibly other filtered signals generated by other analog filter circuits 201 to generate the frequency band of the wideband analog signal.

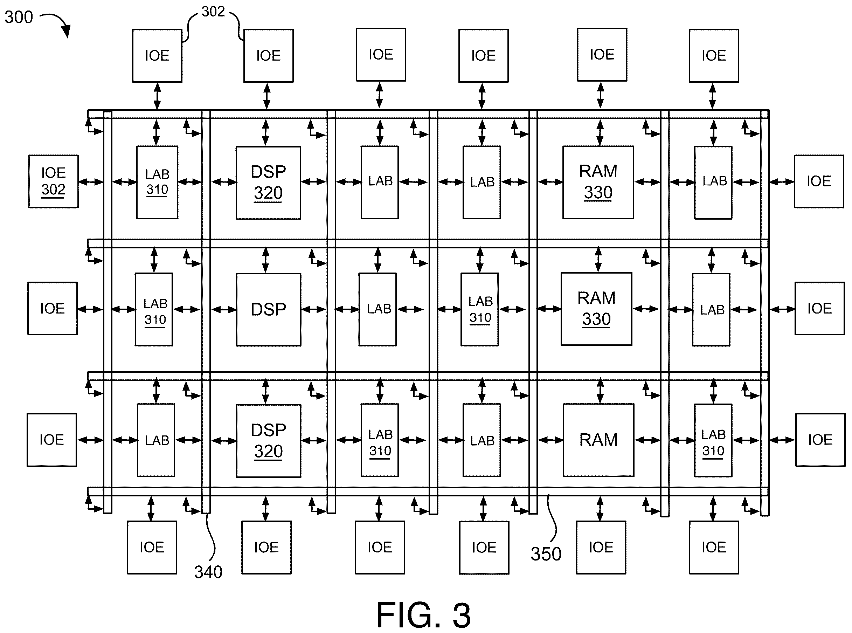

Figure (FIG.) 3 is a diagram that illustrates an example of a configurable logic IC 300 that can implement techniques disclosed herein. The circuits disclosed herein with respect to FIGS. 1-2 can be formed in the configurable logic IC 300 according to an example. As shown in FIG. 3, the configurable logic IC 300 includes a two-dimensional array of configurable functional circuit blocks, including configurable logic array blocks (LABs) 310 and other functional circuit blocks, such as random access memory (RAM) blocks 330 and digital signal processing (DSP) blocks 320. Functional blocks such as LABs 310 can include smaller configurable logic circuits (e.g., logic elements, logic blocks, or adaptive logic modules) that receive input signals and perform custom functions on the input signals to produce output signals.

In addition, configurable logic IC 300 can have input/output elements (IOEs) 302 for driving signals off of configurable logic IC 300 and for receiving signals from other devices. IOEs 302 may include parallel input/output circuitry, serial data transceiver circuitry, differential receiver and transmitter circuitry, or other circuitry used to connect one integrated circuit to another integrated circuit. As shown, IOEs 302 may be located around the periphery of the chip. If desired, the configurable logic IC 300 may have IOEs 302 arranged in different ways. For example, IOEs 302 may form one or more columns, rows, or islands of input/output elements that may be located anywhere on the configurable IC 300. Input/output elements 302 can include general purpose input/output (GPIO) circuitry (e.g., on the top and bottoms edges of IC 300), high-speed input/output (HSIO) circuitry (e.g., on the left edge of IC 300), and on-package input/output (OPIOs) circuitry (e.g., on the right edge of IC 300).

The configurable logic IC 300 can also include programmable interconnect circuitry in the form of vertical routing channels 340 (i.e., interconnects formed along a vertical axis of configurable logic IC 300) and horizontal routing channels 350 (i.e., interconnects formed along a horizontal axis of configurable logic IC 300), each routing channel including at least one track to route at least one wire. One or more of the routing channels 340 and/or 350 can be part of a network-on-chip (NOC) having router circuits.

Note that other routing topologies, besides the topology of the interconnect circuitry depicted in FIG. 3, can be used. For example, the routing topology may include wires that travel diagonally or that travel horizontally and vertically along different parts of their extent as well as wires that are perpendicular to the device plane in the case of three dimensional integrated circuits. The driver of a wire may be located at a different point than one end of a wire.

Furthermore, it should be understood that embodiments disclosed herein with respect to FIGS. 1-2 can be implemented in any integrated circuit or electronic system. If desired, the functional blocks of such an integrated circuit can be arranged in more levels or layers in which multiple functional blocks are interconnected to form still larger blocks. Other device arrangements can use functional blocks that are not arranged in rows and columns.

Configurable logic IC 300 can contain programmable memory elements. Memory elements can be loaded with configuration data bits using IOEs 302. Once loaded, the memory elements each provide a corresponding static control signal that controls the operation of an associated configurable functional block (e.g., LABs 310, DSP blocks 320, RAM blocks 330, or IOEs 302). The configuration data bits can set the functions of the configurable functional circuit blocks (i.e., soft logic) in IC 300.

In a typical scenario, the outputs of the loaded memory elements are applied to the gates of field-effect transistors in a functional block to turn certain transistors on or off and thereby configure the logic in the functional block including the routing paths. Programmable logic circuit elements that are controlled in this way include parts of multiplexers (e.g., multiplexers used for forming routing paths in interconnect circuits), look-up tables, logic arrays, AND, OR, NAND, and NOR logic gates, pass gates, etc.

The memory elements can use any suitable volatile and/or non-volatile memory structures such as random-access-memory (RAM) cells, fuses, antifuses, programmable read-only-memory memory cells, mask-programmed and laser-programmed structures, combinations of these structures, etc. Because the memory elements are loaded with configuration data bits during programming, the memory elements are sometimes referred to as configuration memory or programmable memory elements.

The memory elements can be organized in a configuration memory array consisting of rows and columns. A data register that spans across all columns and an address register that spans across all rows may receive configuration data bits. The configuration data bits can be shifted onto the data register. When the appropriate address register is asserted, the data register writes the configuration data bits to the configuration memory bits of the row that was designated by the address register.

Configurable integrated circuit 300 can include configuration memory that is organized in sectors, whereby a sector can include the configuration bits that specify the function and/or interconnections of the subcomponents and wires in or crossing that sector. Each sector can include separate data and address registers.

The configurable IC of FIG. 3 is merely one example of an IC that can include embodiments disclosed herein. The embodiments disclosed herein may be incorporated into any suitable integrated circuit or system. For example, the embodiments disclosed herein can be incorporated into numerous types of devices such as processor integrated circuits, central processing units, memory integrated circuits, graphics processing unit integrated circuits, application specific standard products (ASSPs), application specific integrated circuits (ASICs), and programmable logic integrated circuits. Examples of programmable logic integrated circuits include programmable arrays logic (PALs), programmable logic arrays (PLAs), field programmable logic arrays (FPLAs), electrically programmable logic devices (EPLDs), electrically erasable programmable logic devices (EEPLDs), logic cell arrays (LCAs), complex programmable logic devices (CPLDs), and field programmable gate arrays (FPGAs), just to name a few.

The integrated circuits disclosed in one or more embodiments herein may be part of a data processing system that includes one or more of the following components: a processor; memory; input/output circuitry; and peripheral devices. The data processing system can be used in a wide variety of applications, such as computer networking, data networking, instrumentation, video processing, digital signal processing, or any suitable other application. The integrated circuits can be used to perform a variety of different logic functions.

In general, software and data for performing any of the functions disclosed herein can be stored in non-transitory computer readable storage media. Non-transitory computer readable storage media is tangible computer readable storage media that stores data and software for access at a later time, as opposed to media that only transmits propagating electrical signals (e.g., wires). The software code may sometimes be referred to as software, data, program instructions, instructions, or code. The non-transitory computer readable storage media can, for example, include computer memory chips, non-volatile memory such as non-volatile random-access memory (NVRAM), one or more hard drives (e.g., magnetic drives or solid state drives), one or more removable flash drives or other removable media, compact discs (CDs), digital versatile discs (DVDs), Blu-ray discs (BDs), other optical media, and floppy diskettes, tapes, or any other suitable memory or storage device(s).

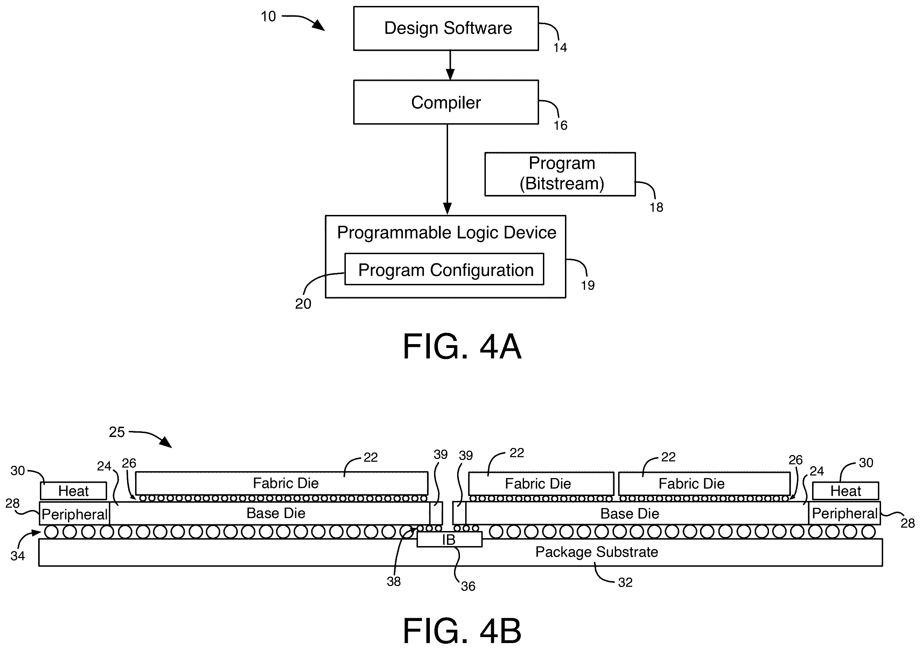

Figure 4A illustrates a block diagram of a system 10 that can be used to implement a circuit design to be programmed onto a programmable logic device 19 using design software. A designer can implement circuit design functionality on an integrated circuit, such as a reconfigurable programmable logic device 19 (e.g., a field programmable gate array (FPGA)). The designer can implement the circuit design to be programmed onto the programmable logic device 19 using design software 14. The design software 14 can use a compiler 16 to generate a low-level circuit-design program (bitstream) 18, sometimes known as a program object file and/or configuration program, that programs the programmable logic device 19. Thus, the compiler 16 can provide machine-readable instructions representative of the circuit design to the programmable logic device 19. For example, the programmable logic device 19 can receive one or more programs (bitstreams) 18 that describe the hardware implementations that should be stored in the programmable logic device 19. A program (bitstream) 18 can be programmed into the programmable logic device 19 as a configuration program 20. The configuration program 20 can, in some cases, represent an accelerator function to perform for machine learning, video processing, voice recognition, image recognition, or other highly specialized tasks.

In some implementations, a programmable logic device can be any integrated circuit device that includes a programmable logic device with two separate integrated circuit die where at least some of the programmable logic fabric is separated from at least some of the fabric support circuitry that operates the programmable logic fabric. One example of such a programmable logic device is shown in FIG. 4B, but many others can be used, and it should be understood that this disclosure is intended to encompass any suitable programmable logic device where programmable logic fabric and fabric support circuitry are at least partially separated on different integrated circuit die.

Figure 4B is a diagram that depicts an example of the programmable logic device 25 that includes three fabric die 22 and two base die 24 that are connected to one another via microbumps 26. In the example of FIG. 4B, at least some of the programmable logic fabric of the programmable logic device 25 is in the three fabric die 22, and at least some of the fabric support circuitry that operates the programmable logic fabric is in the two base die 24. For example, some of the circuitry of configurable IC 300 shown in FIG. 3 (e.g., LABs 310, DSP 320, RAM 330) can be located in the fabric die 22 and some of the circuitry of IC 300 (e.g., input/output elements 302) can be located in the base die 24.

Although the fabric die 22 and base die 24 appear in a one-to-one relationship or a two-to-one relationship in FIG. 4B, other relationships can be used. For example, a single base die 24 can attach to several fabric die 22, or several base die 24 can attach to a single fabric die 22, or several base die 24 can attach to several fabric die 22 (e.g., in an interleaved pattern). Peripheral circuitry 28 can be attached to, embedded within, and/or disposed on top of the base die 24, and heat spreaders 30 can be used to reduce an accumulation of heat on the programmable logic device 25. The heat spreaders 30 can appear above, as pictured, and/or below the package (e.g., as a double-sided heat sink). The base die 24 can attach to a package substrate 32 via conductive bumps 34. In the example of FIG. 4B, two pairs of fabric die 22 and base die 24 are shown communicatively connected to one another via an interconnect bridge 36 (e.g., an embedded multi-die interconnect bridge (EMIB)) and microbumps 38 at bridge interfaces 39 in base die 24.

In combination, the fabric die 22 and the base die 24 can operate in combination as a programmable logic device 25 such as a field programmable gate array (FPGA). It should be understood that an FPGA can, for example, represent the type of circuitry, and/or a logical arrangement, of a programmable logic device when both the fabric die 22 and the base die 24 operate in combination. Moreover, an FPGA is discussed herein for the purposes of this example, though it should be understood that any suitable type of programmable logic device can be used.

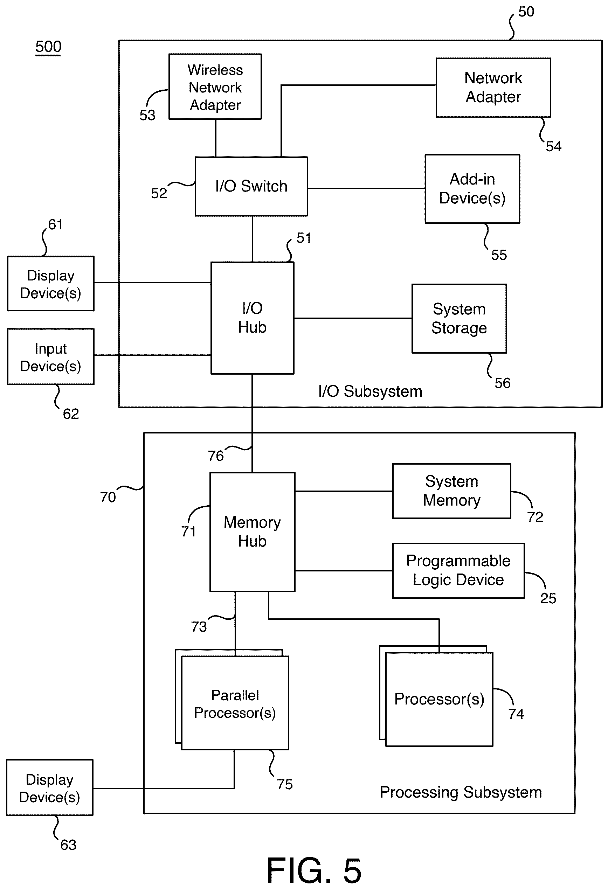

Figure 5 is a block diagram illustrating a computing system 500 configured to implement one or more aspects of the embodiments described herein. The computing system 500 includes a processing subsystem 70 having one or more processor(s) 74, a system memory 72, and a programmable logic device 25 communicating via an interconnection path that can include a memory hub 71. The memory hub 71 can be a separate component within a chipset component or can be integrated within the one or more processor(s) 74. The memory hub 71 couples with an input/output (I/O) subsystem 50 via a communication link 76. The I/O subsystem 50 includes an input/output (I/O) hub 51 that can enable the computing system 500 to receive input from one or more input device(s) 62. Additionally, the I/O hub 51 can enable a display controller, which can be included in the one or more processor(s) 74, to provide outputs to one or more display device(s) 61. In one embodiment, the one or more display device(s) 61 coupled with the I/O hub 51 can include a local, internal, or embedded display device.

In one embodiment, the processing subsystem 70 includes one or more parallel processor(s) 75 coupled to memory hub 71 via a bus or other communication link 73. The communication link 73 can use one of any number of standards based communication link technologies or protocols, such as, but not limited to, PCI Express, or can be a vendor specific communications interface or communications fabric. In one embodiment, the one or more parallel processor(s) 75 form a computationally focused parallel or vector processing system that can include a large number of processing cores and/or processing clusters, such as a many integrated core (MIC) processor. In one embodiment, the one or more parallel processor(s) 75 form a graphics processing subsystem that can output pixels to one of the one or more display device(s) 61 coupled via the I/O Hub 51. The one or more parallel processor(s) 75 can also include a display controller and display interface (not shown) to enable a direct connection to one or more display device(s) 63.

Within the I/O subsystem 50, a system storage unit 56 can connect to the I/O hub 51 to provide a storage mechanism for the computing system 500. An I/O switch 52 can be used to provide an interface mechanism to enable connections between the I/O hub 51 and other components, such as a network adapter 54 and/or a wireless network adapter 53 that can be integrated into the platform, and various other devices that can be added via one or more add-in device(s) 55. The network adapter 54 can be an Ethernet adapter or another wired network adapter. The wireless network adapter 53 can include one or more of a Wi-Fi, Bluetooth, near field communication (NFC), or other network device that includes one or more wireless radios.

The computing system 500 can include other components not shown in FIG. 5, including other port connections, optical storage drives, video capture devices, and the like, that can also be connected to the I/O hub 51. Communication paths interconnecting the various components in FIG. 5 can be implemented using any suitable protocols, such as PCI (Peripheral Component Interconnect) based protocols (e.g., PCI-Express), or any other bus or point-to-point communication interfaces and/or protocol(s), such as the NV-Link high-speed interconnect, or interconnect protocols known in the art.

In one embodiment, the one or more parallel processor(s) 75 incorporate circuitry optimized for graphics and video processing, including, for example, video output circuitry, and constitutes a graphics processing unit (GPU). In another embodiment, the one or more parallel processor(s) 75 incorporate circuitry optimized for general purpose processing, while preserving the underlying computational architecture. In yet another embodiment, components of the computing system 500 can be integrated with one or more other system elements on a single integrated circuit. For example, the one or more parallel processor(s) 75, memory hub 71, processor(s) 74, and I/O hub 51 can be integrated into a system on chip (SoC) integrated circuit. Alternatively, the components of the computing system 500 can be integrated into a single package to form a system in package (SIP) configuration. In one embodiment, at least a portion of the components of the computing system 500 can be integrated into a multi-chip module (MCM), which can be interconnected with other multi-chip modules into a modular computing system.

The computing system 500 shown herein is illustrative. Other variations and modifications are also possible. The connection topology, including the number and arrangement of bridges, the number of processor(s) 74, and the number of parallel processor(s) 75, can be modified as desired. For instance, in some embodiments, system memory 72 is connected to the processor(s) 74 directly rather than through a bridge, while other devices communicate with system memory 72 via the memory hub 71 and the processor(s) 74. In other alternative topologies, the parallel processor(s) 75 are connected to the I/O hub 51 or directly to one of the one or more processor(s) 74, rather than to the memory hub 71. In other embodiments, the I/O hub 51 and memory hub 71 can be integrated into a single chip. Some embodiments can include two or more sets of processor(s) 74 attached via multiple sockets, which can couple with two or more instances of the parallel processor(s) 75.

Some of the particular components shown herein are optional and may not be included in all implementations of the computing system 500. For example, any number of add-in cards or peripherals can be supported, or some components can be eliminated. Furthermore, some architectures can use different terminology for components similar to those illustrated in FIG. 5. For example, the memory hub 71 can be referred to as a Northbridge in some architectures, while the I/O hub 51 can be referred to as a Southbridge.

Additional examples are now described. Example 1 is an integrated circuit comprising: filter circuits that partition a wideband digital signal in a frequency domain to generate narrowband digital signals each having a different frequency band; digital-to-analog converter circuits that convert the narrowband digital signals to analog signals; and an analog combiner circuit that combines the analog signals into a single wideband analog signal.

In Example 2, the integrated circuit of Example 1 may optionally include, wherein the filter circuits generate each of the narrowband digital signals at a baseband.

In Example 3, the integrated circuit of any one of Examples 1-2 may optionally include, wherein the filter circuits cause the narrowband digital signals to comprise frequency bands of the wideband digital signal.

In Example 4, the integrated circuit of any one of Examples 1-3 may optionally include, wherein the filter circuits cause each of the narrowband digital signals to have a bandwidth that overlaps the bandwidth of at least one of other ones of the narrowband digital signals.

In Example 5, the integrated circuit of any one of Examples 1-4 may optionally include, wherein each of the digital-to-analog converter circuits converts one of the narrowband digital signals to generate one of the analog signals.

In Example 6, the integrated circuit of any one of Examples 1-5 may optionally include, wherein the digital-to-analog converter circuits relocate each of the different frequency bands of the narrowband digital signals so that bands of the analog signals are interleaved in frequency.

In Example 7, the integrated circuit of any one of Examples 1-6 may optionally include, wherein the analog combiner circuit combines frequency bands of the analog signals to cause the single wideband analog signal to comprise a contiguous and non-distorted frequency spectrum.

In Example 8, the integrated circuit of any one of Examples 1-7 further comprises analog filter circuits that filter the analog signals generated by the digital-to-analog converter circuits to generate filtered signals, wherein the analog combiner circuit combines the filtered signals into the single wideband analog signal.

Example 9 is a method for converting a wideband digital signal into a wideband analog signal, the method comprising: filtering the wideband digital signal in a frequency domain using filter circuits to generate narrowband digital signals, wherein each of the narrowband digital signals comprises a frequency band that is different than frequency bands of other ones of the narrowband digital signals; converting the narrowband digital signals to analog signals using digital-to-analog converter circuits; and combining the analog signals into the wideband analog signal using an analog combiner circuit.

In Example 10, the method of Example 9 may optionally include, wherein filtering the wideband digital signal in the frequency domain to generate the narrowband digital signals further comprises generating each of the narrowband digital signals at a baseband.

In Example 11, the method of any one of Examples 9-10 may optionally include, wherein filtering the wideband digital signal in the frequency domain to generate the narrowband digital signals further comprises causing each of the narrowband digital signals to have a bandwidth that overlaps the bandwidth of at least one of the other ones of the narrowband digital signals.

In Example 12, the method of any one of Examples 9-11 may optionally include, wherein converting the narrowband digital signals to the analog signals further comprises converting each of the narrowband digital signals to one of the analog signals using one of the digital-to-analog converter circuits.

In Example 13, the method of any one of Examples 9-12 may optionally include, wherein converting the narrowband digital signals to the analog signals further comprises placing each of the frequency bands of the narrowband digital signals using the digital-to-analog converter circuits to cause bands of the analog signals to be interleaved in frequency.

In Example 14, the method of any one of Examples 9-13 may optionally include, wherein combining the analog signals into the wideband analog signal further comprises combining bands of the analog signals using the analog combiner circuit to cause the wideband analog signal to comprise a contiguous and non-distorted frequency spectrum.

In Example 15, the method of any one of Examples 9-14 further comprises filtering the analog signals generated by the digital-to-analog converter circuits using analog filter circuits to generate filtered signals, wherein combining the analog signals into the wideband analog signal further comprises combining the filtered signals into the wideband analog signal using the analog combiner circuit.

Example 16 is a conversion circuit comprising: filter circuits that filter first frequency bands of a wideband digital signal to generate narrowband digital signals that each comprise one of the first frequency bands of the wideband digital signal; digital-to-analog converter circuits that generate analog signals comprising second frequency bands that are interleaved, wherein each of the digital-to-analog converter circuits converts one of the narrowband digital signals into one of the analog signals; and an analog combiner circuit that combines the second frequency bands of the analog signals to generate frequencies of a wideband analog signal.

In Example 17, the conversion circuit of Example 16 may optionally include, wherein the filter circuits generate each of the narrowband digital signals at a baseband.

In Example 18, the conversion circuit of any one of Examples 16-17 may optionally include, wherein each of the filter circuits causes one of the narrowband digital signals to have a bandwidth that overlaps the bandwidth of at least one of other ones of the narrowband digital signals.

In Example 19, the conversion circuit of any one of Examples 16-18 may optionally include, wherein the analog combiner circuit combines the second frequency bands of the analog signals to cause the wideband analog signal to comprise a contiguous and non-distorted frequency spectrum.

In Example 20, the conversion circuit of any one of Examples 16-19 further comprises analog filter circuits that filter the analog signals generated by the digital-to-analog converter circuits to generate filtered signals, wherein the analog combiner circuit combines the filtered signals into the wideband analog signal.

The foregoing description of the exemplary embodiments has been presented for the purpose of illustration. The foregoing description is not intended to be exhaustive or to be limiting to the examples disclosed herein. The foregoing is merely illustrative of the principles of this disclosure and various modifications can be made by those skilled in the art. The foregoing embodiments may be implemented individually or in any combination.

## Claims

1. An integrated circuit comprising:
filter circuits that partition a wideband digital signal in a frequency domain to generate narrowband digital signals each having a different frequency band;
digital-to-analog converter circuits that convert the narrowband digital signals to analog signals; and
an analog combiner circuit that combines the analog signals into a single wideband analog signal.

2. The integrated circuit of claim 1, wherein the filter circuits generate each of the narrowband digital signals at a baseband.

3. The integrated circuit of any one of claims 1-2, wherein the filter circuits cause the narrowband digital signals to comprise frequency bands of the wideband digital signal.

4. The integrated circuit of any one of claims 1-3, wherein the filter circuits cause each of the narrowband digital signals to have a bandwidth that overlaps the bandwidth of at least one of other ones of the narrowband digital signals.

5. The integrated circuit of any one of claims 1-4, wherein each of the digital-to-analog converter circuits converts one of the narrowband digital signals to generate one of the analog signals.

6. The integrated circuit of any one of claims 1-5, wherein the digital-to-analog converter circuits relocate each of the different frequency bands of the narrowband digital signals so that bands of the analog signals are interleaved in frequency.

7. The integrated circuit of any one of claims 1-6, wherein the analog combiner circuit combines frequency bands of the analog signals to cause the single wideband analog signal to comprise a contiguous and non-distorted frequency spectrum.

8. The integrated circuit of any one of claims 1-7 further comprising:
analog filter circuits that filter the analog signals generated by the digital-to-analog converter circuits to generate filtered signals, wherein the analog combiner circuit combines the filtered signals into the single wideband analog signal.

9. A method for converting a wideband digital signal into a wideband analog signal, the method comprising:
filtering the wideband digital signal in a frequency domain using filter circuits to generate narrowband digital signals, wherein each of the narrowband digital signals comprises a frequency band that is different than the frequency bands of other ones of the narrowband digital signals;
converting the narrowband digital signals to analog signals using digital-to-analog converter circuits; and
combining the analog signals into the wideband analog signal using an analog combiner circuit.

10. The method of claim 9, wherein filtering the wideband digital signal in the frequency domain to generate the narrowband digital signals further comprises generating each of the narrowband digital signals at a baseband.

11. The method of any one of claims 9-10, wherein filtering the wideband digital signal in the frequency domain to generate the narrowband digital signals further comprises causing each of the narrowband digital signals to have a bandwidth that overlaps the bandwidth of at least one of the other ones of the narrowband digital signals.

12. The method of one of claims 9-11, wherein converting the narrowband digital signals to the analog signals further comprises converting each of the narrowband digital signals to one of the analog signals using one of the digital-to-analog converter circuits.

13. The method of one of claims 9-12, wherein converting the narrowband digital signals to the analog signals further comprises placing each of the frequency bands of the narrowband digital signals using the digital-to-analog converter circuits to cause bands of the analog signals to be interleaved in frequency.

14. The method of one of claims 9-13, wherein combining the analog signals into the wideband analog signal further comprises combining bands of the analog signals using the analog combiner circuit to cause the wideband analog signal to comprise a contiguous and non-distorted frequency spectrum.

15. The method of one of claims 9-14 further comprising:
filtering the analog signals generated by the digital-to-analog converter circuits using analog filter circuits to generate filtered signals, wherein combining the analog signals into the wideband analog signal further comprises combining the filtered signals into the wideband analog signal using the analog combiner circuit.
